# EUROPEAN PATENT APPLICATION

(11) **EP 1 382 708 A2**
(43) Date of publication of application: **21.01.2004**
(21) Application number: 03394061.0
(22) Date of filing: 02.07.2003
(51) Int. Cl.: C23C 14/00

(54) **Surface recovery of contaminated deposition tools**

(30) Priority: 03.07.2002 IE 20020546
(71) Applicant: OMC Scientific Research Limited, Limerick (IE)
(72) Inventor: Dillon, Patrick, Castletroy, County Limerick (IE); Comerford, Thomas, Thurles, County Tipperary (IE); O'Mahony, Joseph Patrick, County Clare (IE); McMeel, John, Ballysheedy, County Limerick (IE); Gibbons, Richard, Hamble Lane, Southampton SO 31 4JS (GB)
(74) Representative: Weldon, Michael James

(57) **Abstract**

A process for treating a contaminated tool previously used for vapour or other deposition is disclosed. The process comprises chemical oxidation (3) followed by abrasive blasting (4) and rinsing (5). Contaminated material is removed by acid (3, 6) and water used for high pressure spray rinsing (5). Such removal involves one or more of sequestration followed by filter press, coarse filter mesh in bath weir return, and use of magnets. Drying (12) is performed without direct heat input, temperature rise of the tool being achieved by clean air recirculation by centrifuge fan into a vortex release. The dried tool is packed (15) with inert gas purging in a cleanroom for shipment and re-use.

## Description

### INTRODUCTION

### Field of the Invention

The invention relates to surface recovery treatment of tools used for deposition processes such as vapour deposition, vacuum sputtering, gaseous reaction, or centrifuge.

### Prior Art Discussion

These deposition processes are typically used to deposit multiple layer conductive or insulating films on wafer or disc products in the production of micro miniature circuits or data tracks for semiconductor, micro and opto- electronic devices. The invention is particularly concerned with treatment of tools used for deposition within a particulate controlled cleanroom environment as defined in ISO 14644.

Such tooling may, for example, be used to contain or mask the deposition media during the deposition process and is normally fabricated from high quality stainless steel, ceramic or quartz substrate. The contaminant coatings themselves typically consist of an amalgam of precious and rare metals such as copper, chrome, cobalt, gold, iridium, platinum, silicon, tantalum, tungsten, or vanadium, and organic films formed by gaseous reaction or direct deposition. Since these would be applied in strict discipline, a trace element of material arriving out of sequence becomes a contaminant, leading to possible batch rejection. Accumulated film build-up on the surface of the tooling ranges from a few microns of organic residue to several millimetres of tungsten carbide, silver or gold, acerbates this situation.

Thus there is a need for routine removal of the tooling, elimination of built up films and restoration of its substrate to finite surface condition levels, defined as "Equivalent to New" before re-use. Due to the nature of the recovery process, this work has to be carried out with due regard to the serious environmental impact of the stripping process, the critical demands of cleanroom working and the delicate nature of the tool. Additionally where precious metal has been deposited, stringent recovery methods are required to recover the material value for the client.

The invention is directed towards providing for effective surface recovery treatment and recovery of precious metals where appropriate.

### SUMMARY OF THE INVENTION

According to the invention, there is provided a process for treatment of a contaminated tool used for a deposition process, the treatment process comprising the steps of: -
removing contaminant material from the tool,
rinsing and drying the tool, and
recovering solids from liquids used in the contaminant removal and/or rinsing steps.

In one embodiment, the solids are removed by a filter press.

In another embodiment, the liquids are treated with sequestering chemicals to cause flocculation prior to operation of the filter press.

In a further embodiment, the contaminant removal step comprises dissolving some of the contaminant material by immersion of the tool in an acid bath.

In one embodiment, there are at least two dissolving steps.

In another embodiment, successive dissolving steps are separated by abrasive blasting and rinsing of the tool.

In a further embodiment, a bath comprises potassium hydroxide and hydrogen peroxide.

In one embodiment, a bath comprises ammonium hydroxide and hydrogen peroxide.

In another embodiment, dissolved material is removed by filtering the acid.

In a further embodiment, the process comprises the further step of recovering metal from the acid by reverse plating.

In one embodiment, the contaminant removal step comprises mechanically removing some contaminant material by machining.

In another embodiment, the process comprises the further step of abrasive blasting the tool, and extracting solid particles using a magnet in a return duct.

In a further embodiment, the process comprises the further step of ultrasonic cleaning the tool in a water bath after removal of the contaminant material.

In one embodiment, the ionic balance of water for ultrasonic cleaning is maintained by ion exchange.

In another embodiment, the tool is dried using an air recirculation for adiabatic heat generation.

In a further embodiment, the air recirculation is by operation of a centrifugal fan driving the air into a vortex release.

In one embodiment, said drying takes place without direct heat input, the air recirculation raising the tool temperature.

In another embodiment, drying take place in a cleanroom environment.

In a further embodiment, drying takes place in a sealed enclosure.

In one embodiment, the treated tool is packed in an inert gas-filled cleanroom film.

In another embodiment, a digital image of the tool surface is captured before packing, and each tool is inspected before treatment to identity it from any previous treatment.

### DETAILED DESCRIPTION OF THE INVENTION

### Brief Description of the Drawings

The invention will be more clearly understood from the following description of some embodiments thereof, given by way of example only with reference to the accompanying drawing which is a flow diagram illustrating a tool treatment process of the invention.

### Description of the Embodiments

The invention provides a process for recovering contaminated tooling and restoring it to "Equivalent to New" condition for re-use, within a process capable of recovering process and material waste and monitoring the tool life stage. The process removes and recovers excess material deposits from the tool and presents the tool for re-use by:
chemical immersion and abrasive blasting in a closed loop recycled environment,
precision cleaning and drying in a particulate free environment,
packing the tool within inert- gas sealed cleanroom packaging, and
computer based lifecycle tracking of the tool recovery process.

Specific rare metal species are, where appropriate, recovered from waste arising from the removal step. Also, copper or aluminium may be deposited, preferably by arc spraying to improve tool life. The coated tool is cleaned in an ultrasonic bath of de-ionised water and subsequently precision dried in a turbo cyclone before packaging in clean film, purged with inert gas. The tool condition, life and process exposure is tracked by a computer-based control system.

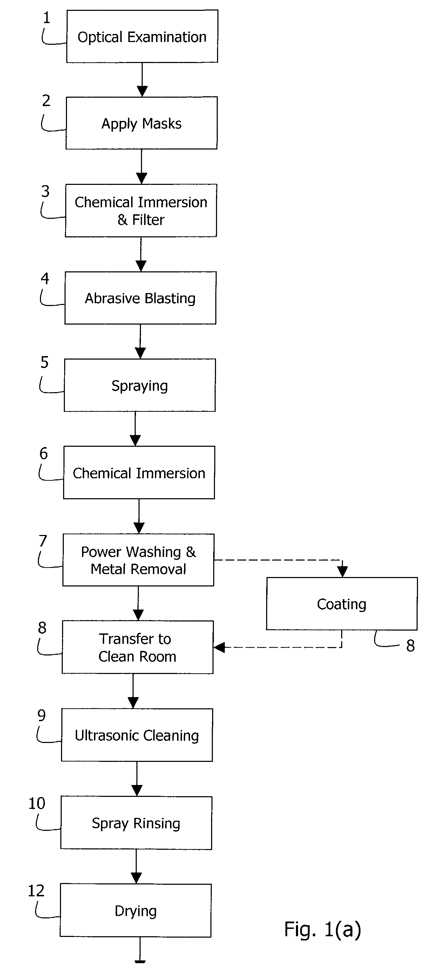

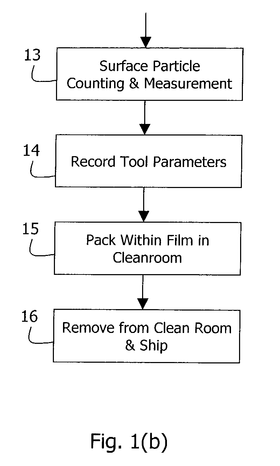

In more detail, in one embodiment the process comprises the following steps, with reference to the flow diagram of Figs. 1(a) and 1(b).
1. Optical examination of the tool to determine the type and thickness of coating (contaminant) and reference to records of its previous progression through the recovery system to determine inherent faults and predicted life exposure. The tool may be of any appropriate shape and configuration, according to the task it performs. It may, for example, be a frusto-conical ring or a flange-shaped ring.
2. Application of bolt-on metal masks to prevent chemical or abrasive attack in delicate areas. The bolt fasteners use existing aperture in the tool.
3. Chemical immersion of the component in shallow depth potassium hydroxide and hydrogen peroxide solutions pumped from a base to a fixed depth weir so that the chemical depth is always at constant level. Removed particulate material is then filtered from a coarse filter mesh positioned in the weir return.
   The mesh is a perforated sheet directly below the components or in a pump filter cartridge.
4. Abrasive blasting of the tool using closed loop cyclone extraction with use of samarium-cobalt high-energy magnets in the return ducts for capture of magnetic co-depositions such as platinum- iron. There may also be machining of the tool for physical removal of contaminant material. Such machining may alternatively be performed before step 3.
5. 1200 psi water spraying to remove abrasive media from holes or surface pores, water being returned to the effluent plant for pH neutralisation and gravity separation of media.
6. Controlled depth chemical immersion of the tool in ammonium hydroxide-hydrogen peroxide solutions cooled with localised coils of chilled water to prevent solution evaporation from the exothermic reaction. The spent acid is processed in a reverse plating bath to recover dissolved metals, particularly precious metals.
7. Additional power washing controlled as in step 5 with water fed to the effluent plant, where metal removal is achieved by the addition of polyelectrolyte chemicals to the collected waste stream. These encourage metal sequestration into the viscous waste which is then passed through a filter press to concentrate the solid content for salvage.
8. Optional coating of arc-sprayed copper or aluminium films to the tool to increase its surface roughness, this improves the tool performance during sputtering when it is back in use and facilitates the removal of the built up films when the tool subsequently returns for surface recovery.
9. Removal to controlled environment (cleanroom).
10. Ultrasonic cleaning using horizontally opposed transducers configured to focus the sonic energy pattern on the critical tool faces with full electronic control of sonic-power, natural and sweep frequency to prevent surface damage. Solid impurities are removed by super fine filtration and the ionic balance of the water is maintained by trickle feeding the surface water weirs to the facility DI water plant, for correction by ion exchange in the normal manner.
11. Spray rinsing in ultimate quality de-ionised water, taken directly from the DI water supply loop, and returned to the treatment plant for ionic control and fine particle removal.
12. Drying by placement in a sealed enclosure of cleanroom air, compressed by high-speed recirculation via centrifugal fan into a vortex release. The adiabatic heat generation is sufficient to raise the ambient temperature by 50°C which in conjunction with the degree of air movement is sufficient to dry the tooling without external heat or particle addition. This may be referred to as a "cyclone drier".
13. Surface particle counting at 0.3 microns, using a vacuum attachment to a conventional laser particle counter. This is followed by physical measurement of key tooling features to ensure that the tool continues to meet dimensional requirements.
14. Computer recording of tool cleanliness, dimensions and life cycle state substantiated by digital photograph. This is typically in advance of shipment.
15. Packing in double- bagged inert-gas filled, cleanroom film.
16. Removal from controlled environment.

During the process all process water is re-cycled by neutralisation, filtration, sequestration of solid and ultimate filter pressing to compact the recovered waste product. Fume emissions are also scrubbed using turbulent water cascades, which are also fed to the effluent system for neutralisation and subsequent re-use.

It has been found that this process provides for effective removal of metallic and organic coatings on most deposition tools. Also, it provides for recovery of rare and base metal species by the use of:
- the filtering operations such as magnetic extraction from the cyclone in the blast media recovery stage,
- sequestering chemicals to initiate precipitation from the effluent water, with subsequent salvage by filter press, and
- reverse plating cells for recovery of precious metal from spent acid.

An advantageous aspect of the process is that the recovered tool can be demonstrated to be particle free and clear of any ionic or organic contaminants, remaining from the original deposition or the stripping process. This is achieved by 100% surface particle measurement in the clean room and full chemical analysis at the time of validation. Subsequent processing is made using ISO verified process control techniques supported by digitally recorded product photographs for instant cross-reference. This record becomes an important part of a life cycle tracking procedure for the tool.

The invention is not limited to the embodiments described but may be varied in construction and detail. For example, different chemical compositions can be used for chemical immersion depending on the nature of the contaminant material.

## Claims

1. A process for treatment of a contaminated tool used for a deposition process, the treatment process comprising the steps of:-
removing contaminant material from the tool,
rinsing and drying the tool, and
recovering solids from liquids used in the contaminant removal and/or rinsing steps.

2. A process as claimed in claim 1, wherein the solids are removed by a filter press.

3. A process as claimed in claim 2, wherein the liquids are treated with sequestering chemicals to cause flocculation prior to operation of the filter press.

4. A process as claimed in any preceding claim, wherein the contaminant removal step comprises dissolving some of the contaminant material by immersion of the tool in an acid bath.

5. A process as claimed in claim 4, wherein there are at least two dissolving steps.

6. A process as claimed in claim 5, wherein successive dissolving steps are separated by abrasive blasting and rinsing of the tool.

7. A process as claimed in claims 5 or 6, wherein a bath comprises potassium hydroxide and hydrogen peroxide.

8. A process as claimed in any of claims 5 to 7, wherein a bath comprises ammonium hydroxide and hydrogen peroxide.

9. A process as claimed in claims 4 to 8, wherein dissolved material is removed by filtering the acid.

10. A process as claimed in claim 4 to 9, comprising the further step of recovering metal from the acid by reverse plating.

11. A process as claimed in any preceding claim, wherein the contaminant removal step comprises mechanically removing some contaminant material by machining.

12. A process as claimed in any preceding claim, comprising the further step of abrasive blasting the tool, and extracting solid particles using a magnet in a return duct.

13. A process as claimed in any preceding claim, comprising the further step of ultrasonic cleaning the tool in a water bath after removal of the contaminant material.

14. A process as claimed in claims 13, wherein the ionic balance of water for ultrasonic cleaning is maintained by ion exchange.

15. A process as claimed in any preceding claim, wherein the tool is dried using an air recirculation for adiabatic heat generation.

16. A process as claimed in claim 15, wherein the air recirculation is by operation of a centrifugal fan driving the air into a vortex release.

17. A process as claimed in claims 15 or 16, wherein said drying takes place without direct heat input, the air recirculation raising the tool temperature.

18. A process as claimed in claims 15 or 16, wherein drying take place in a cleanroom environment.

19. A process as claimed in claim 18, wherein drying takes place in a sealed enclosure.

20. A process as claimed in claim 19, wherein the treated tool is packed in an inert gas-filled cleanroom film.

21. A process as claimed in any preceding claim, wherein a digital image of the tool surface is captured before packing, and each tool is inspected before treatment to identity it from any previous treatment.
